(19) Europäisches Patentamt / European Patent Office / Office européen des brevets

(11) **EP 3 850 614 B1**

(12) **EUROPÄISCHE PATENTSCHRIFT**

(45) Veröffentlichungstag und Bekanntmachung des Hinweises auf die Patenterteilung:
**09.07.2025 Patentblatt 2025/28**

(21) Anmeldenummer: **19766230.7**

(22) Anmeldetag: **09.09.2019**

(51) Internationale Patentklassifikation (IPC):
**G09G 3/34** (2006.01)     **H03M 1/80** (2006.01)

(52) Gemeinsame Patentklassifikation (CPC):
**G09G 3/3433; G09G 3/3486;** G09G 2300/0408;
G09G 2300/0828; G09G 2310/0221;
G09G 2310/0248; G09G 2310/0297; H03M 1/804

(86) Internationale Anmeldenummer:
**PCT/EP2019/074010**

(87) Internationale Veröffentlichungsnummer:
**WO 2020/053158 (19.03.2020 Gazette 2020/12)**

(54) **MIKROMECHANISCHE AKTUATOREN MIT INTEGRIERTEN DIGITAL / ANALOG-KONVERTERN, VERFAHREN UND COMPUTERPROGRAMM**

MICROMECHANIAL ACTUATORS WITH INTEGRATED DIGITAL-TO-ANALOG CONVERTERS, METHOD AND COMPUTER PROGRAM

ACTIONNEURS MICROMÉCANIQUES AVEC CONVERTISSEURS NUMÉRIQUES/ANALOGIQUES INTÉGRÉS, PROCÉDÉ ET PROGRAMME INFORMATIQUE

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **11.09.2018 DE 102018215428**

(43) Veröffentlichungstag der Anmeldung:
**21.07.2021 Patentblatt 2021/29**

(73) Patentinhaber: **Fraunhofer-Gesellschaft zur Förderung der angewandten Forschung e.V.**
**80686 München (DE)**

(72) Erfinder:
• **DÜRR, Peter**
**01109 Dresden (DE)**
• **PRESBERGER, Thomas**
**01109 Dresden (DE)**

(74) Vertreter: **Burger, Markus et al**
**Schoppe, Zimmermann, Stöckeler**
**Zinkler, Schenk & Partner mbB**
**Patentanwälte**
**Radlkoferstraße 2**
**81373 München (DE)**

(56) Entgegenhaltungen:
WO-A1-2013/131071    US-A1- 2009 204 350
US-A1- 2012 274 611    US-A1- 2015 348 492
US-A1- 2016 078 842    US-A1- 2016 111 058

• **ANDREAS GEHNER ET AL: "MEMS analog light processing: an enabling technology for adaptive optical phase control", BIOMEDICAL PHOTONICS AND OPTOELECTRONIC IMAGING : 8 - 10 NOVEMBER 2000, BEIJING, CHINA, vol. 6113, 21 January 2006 (2006-01-21), Bellingham, Wash., US, pages 61130K, XP055257131, ISBN: 978-1-62841-832-3, DOI: 10.1117/12.651731**

**Beschreibung**

Die vorliegende Erfindung betrifft eine Vorrichtung mit mikromechanischen Aktuatoren und ein Verfahren zum Ansteuern dieser Aktuatoren.

Mikromechanischen Aktuatoren finden beispielsweise Verwendung in Flächenlichtmodulatoren, die auch als räumliche Modulatoren für Licht / Flächenlichtmodulator und unter dem englischen Begriff Spatial Light Modulator / SLM bekannt sind. Die dafür eingesetzten mikromechanischen Aktuatoren werden nicht nur zwischen zwei Extrempositionen hin- und hergeschaltet, sondern sie können beliebige Auslenkungswerte in einem definierten Arbeitsbereich annehmen. Dies wird beispielsweise durch ein Gleichgewicht zwischen elektrostatischen oder elektromagnetischen Kräften einerseits und rückstellenden Federkräften andererseits erreicht. Derartige elektrisch angetriebene Aktuatoren können dafür genutzt werden, um mikromechanische Elemente mechanisch zu bewegen und diese in eine gewünschte Position zu bringen. Ein bestimmter Wert für eine angelegte analoge elektrische Spannung bestimmt eine zu erreichende Position des mikromechanischen Aktuators.

Eine Vielzahl derartiger mikromechanischer Aktuatoren können beispielsweise auf einem Substrat eines elektronischen Bauteils, beispielsweise eines SLM-Chips, als eindimensionale Reihe oder zweidimensionale Matrix angeordnet sein. In einer Ausführungsform derartiger Vorrichtungen werden eine Vielzahl von Mikrospiegeln mit den mikromechanischen Aktuatoren verbunden, so dass diese Mikrospiegel in ihrer Höhenlage und oder Kippung einstellbar sind, was als Flächenlichtmodulator bezeichnet wird. In diesem Kontext wird ein derartiger Mikrospiegel auch als Pixel bezeichnet.

In bekannten Ausführungsformen wird eine bestimmte Adressspannung über ein analoges Interface durch analoge Schalter auf dem SLM-Chip zu einem entsprechenden mikromechanischen Aktuator durchgeschaltet. Zu den Nachteilen eines solchen analogen Interfaces zählen beispielweise: eine erhöhte Anfälligkeit für Störungen, eine begrenzte Bandbreite der Analogleitungen und eine relativ hohe Verlustleistung des Gesamtsystems.

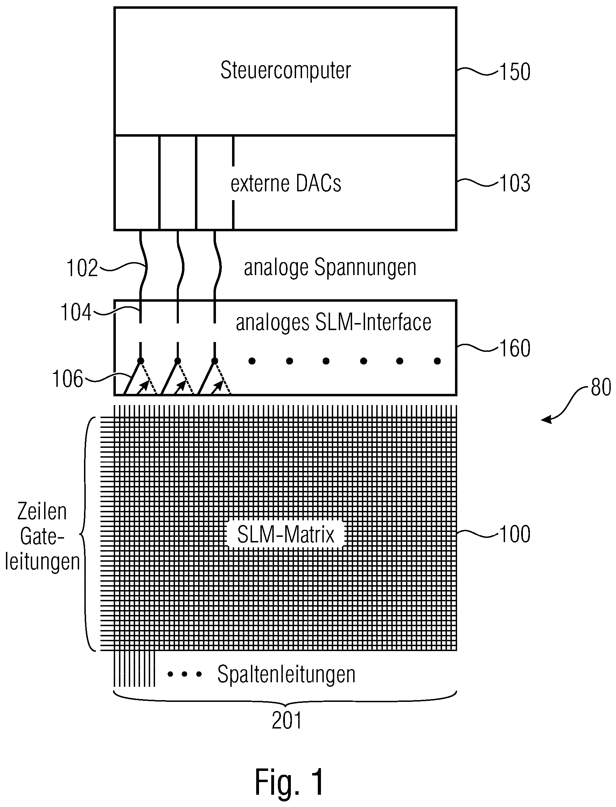

Die relativ hohe Verlustleistung ist dadurch bedingt, dass die Ansteuerschaltung neben der eigentlich gewünschten Last - dem mikromechanischen Aktuator - noch viele weitere, normalerweise weitaus größere parasitäre Lasten mit der vollen Adressspannung beaufschlagen muss. Zu den parasitären Lasten gehören beispielsweise Zuleitungen, Bondpads (zu kontaktierende Flächen eines Halbleiterelements), ESD-(Elektrostatische Entladung-) Schutzschaltungen usw., wobei diese Bauteile bereits aufgrund ihrer Größe einen kompakten Gesamtaufbau des SLM-Chips verhindern können (Fig. 1).

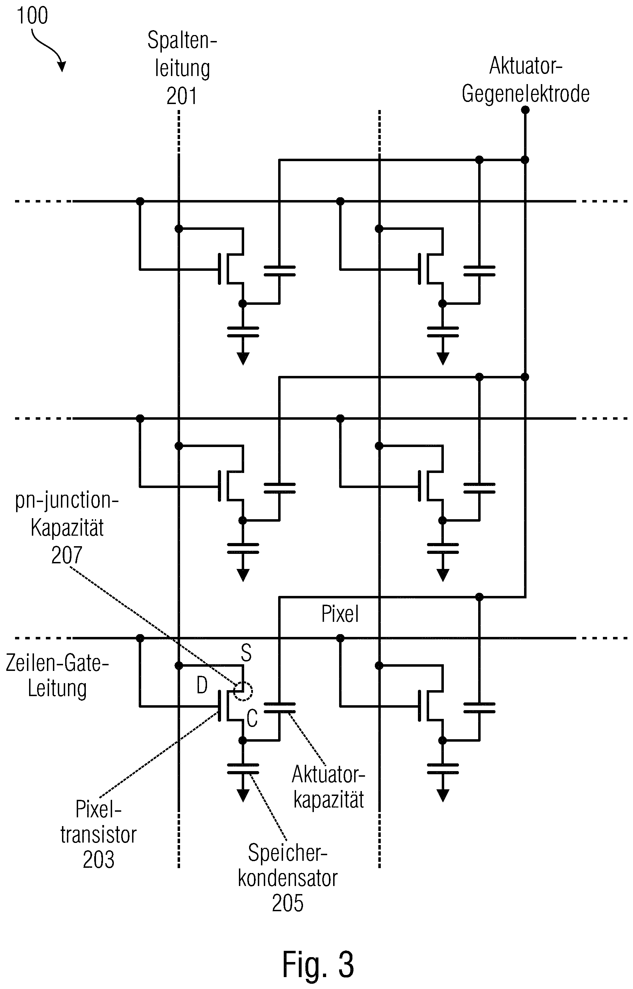

In einem bekannten Ausführungsbeispiel befindet sich unter jedem mikromechanischen Aktuator ein elektronischer Speicherbaustein mit wahlfreiem Zugriff, z.B. eine analoge DRAM-Zelle (dynamic random access memory) mit nur einem Transistor (z. B. ein Pixeltransistor) und einer Speicherkapazität, die einen Adressspannungswert bis zu einem nächsten Refresh speichert. Die analoge Spannung wird in die Matrix zeilenweise eingeschrieben. Dafür werden alle Gates der Pixeltransistoren einer Zeile geöffnet während zur gleichen Zeit die Spaltenleitungen und damit an die Sources der Pixeltransistoren jeweils die gewünschten Spannungen haben. Mit dem Schließen der Gates sind die angelegten Spannungen in den Kapazitäten der Pixelzellen dieser Zeile gespeichert. Alle Pixeltransistor-Sources einer Spalte sind mit der Spaltenleitung verbunden. Die Gesamtkapazität einer solchen Spaltenleitung wird im Wesentlichen durch die pn-Kapazität eines sogenannten Sourcegebiets der Pixeltransistoren bestimmt und steigt daher mit der Größe des Arrays an. Fig. 3 zeigt einen Bereich einer DRAM Struktur eines Flächenlichtmodulators mit drei Speicherzellen an einer Spaltenleitung.

Die Druckschrift US2016111058 A1 beschreibt eine Anzeigevorrichtung mit einem Treiber, der eine Lastleitung eines elektrooptischen Panels durch Umverteilung der Kondensatorladung ansteuert, wobei sich eine Datenspannung in dem Fall ändert, in dem sich die Kapazität eines elektrooptischen Panels ändert, selbst wenn die Tonwerte gleich sind.

Die Druckschrift US2012274611 A1 beschreibt ein Verfahren und eine Vorrichtung, die sich auf Pixeldesigns zur Verwendung in Aktivmatrixanzeigen beziehen, die Poly-Silizium (p-Si) - Dünnschichttransistoren (TFTs) mit Dual-Gate-Strukturen zur Steuerung der Pixel verwenden.

Die Druckschrift von Andreas Gehner, Michael Wildenhain, Hannes Neumann, Jens Knobbe, Ondrej Komenda "MEMS analog light processing: an enabling technology for adaptive optical phase control" bezieht sich auf Anwendungen in der modernen Optik, die auf Spatial Light Modulatoren (SLM) mit einer analoger Lichtverarbeitung, z.B. die Erzeugung beliebiger analoger Phasenmuster für eine adaptive optische Phasenregelung basieren.

Die Druckschrift US2016078842 A1 beschreibt Systeme, Verfahren und Vorrichtungen für ein Stromversorgungsmodul, die in der Lage sind, eine Anzeigevorrichtung mit Strom zu versorgen.

Die Druckschrift US2015348492 A1 bezieht sich allgemein auf eine Anzeigevorrichtung und insbesondere auf eine großformatige Anzeigevorrichtung.

Die Druckschrift US2009204350 A1 bezieht sich auf die Charakterisierung von MEMS-Anzeigen.

Die Druckschrift WO2013131071 A1 bezieht sich auf die Integration eines Flächenlichtmodulators mit eine Digital-Analog-Umsetzer auf dem gleichen Substrat.

Aufgabe der Erfindung ist es, eine möglichst kompakte und verlustarme Vorrichtung mit einer Ansteuerschaltung für mikromechanische Aktuatoren bereitzustellen, die gleichzeitig schnell und präzise arbeitet. Dabei soll eine Vielzahl von analogen Adressspannungswerten für die mikromechanischen Aktuatoren von einer Ansteuerschaltung zu dem SLM-Bauelement übertragen werden.

Die Aufgabe wird durch eine Vorrichtung mit den Merkmalen des kennzeichnenden Teils des Anspruchs 1 gelöst. Dabei ist das Interface des SLM-Bauelements zu seiner Ansteuerschaltung digital ausgebildet, was störungsresistente Signale auf niedrigem Spannungsniveau und damit geringer Verlustleistung ermöglicht. Die Konvertierung der digitalen Signale in analoge Adressspannungen erfolgt dementsprechend auf dem SLM-Chip selbst.

Gemäß einer ersten Ausführungsform umfasst eine Anordnung zum Ansteuern von mikromechanischen Aktuatoren folgende Merkmale: einen Digital-zu-Analog-Wandler und eine Mehrzahl von mikromechanischen Aktuatoren; wobei die mikromechanischen Aktuatoren mit einer Verbindungsstruktur gekoppelt sind; wobei der Digital-zu-Analog-Wandler ausgelegt ist, um eine an die Verbindungsstruktur anzulegende Spannung durch eine einstellbare kapazitive Spannungsteilung, die von einem digitalen Eingangswert des Digital-zu-Analog-Wandlers abhängig ist, bereitzustellen, wobei der Digital-zu-Analog-Wandler ausgelegt ist, um eine Kapazität der Verbindungsstruktur direkt in die kapazitive Spannungsteilung einzubeziehen.

Diese Ausführungsform basiert auf der Erkenntnis, dass es vorteilhaft ist, einen Chip mit mikromechanischen Aktuatoren, beispielsweise einen Flächenlichtmodulator- (SLM-) Chip, mit digitalem Dateninterface sowie Charge Scaling Digital-zu-Analog-Wandler (DACs) zu integrieren, wobei die Kapazität der Spaltenleitung direkt in die kapazitiven Spannungsteiler einbezogen sind und keine Operationsverstärker (OPVs) verwendet werden. Damit ist es möglich die Verlustleistung des OPVs einzusparen und störungsresistente Signale auf niedrigem Spannungsniveau und damit geringer Verlustleistung zu verwenden.

In dieser Ausführungsform umfasst die Verbindungsstruktur eine Verbindungsleitung und eine Mehrzahl von Schalttransistoren, die zwischen Spaltenleitung und Speicherkapazitäten geschaltet sind, die den jeweiligen mikromechanischen Aktuatoren zugeordnet sind. Diese Ausführungsform basiert auf der Erkenntnis, dass es vorteilhaft ist, die an die Verbindungsstruktur angeschlossenen Aktuatoren zeitlich seriell mit neuen Spannungswerten zu beschreiben.

In dieser Ausführungsform ist die Verbindungsleitung passiv ausgebildet. Dieser Ausführungsform liegt die Erkenntnis zugrunde, dass es vorteilhaft ist, die Verbindungsleitung passiv mit einer Mehrzahl von Kondensatoren zu koppeln, um damit eine weitere einstellbare Spannungsteilung bereitzustellen. Eine solche Ausführungsform, benötigt keinen Operationsverstärker am Ausgang als Impedanzwandler, um eine lastunabhängige Spannung zur Verfügung zu stellen. Ein Operationsverstärker würde zusätzliche Leistung benötigen, wobei die Linearität und das Einschwingverhalten zusätzlich beachtet werden müsste.

In einer weiteren Ausführungsform ist die Verbindungsleitung gleichstrommäßig oder direkt mit einer Mehrzahl von geschalteten Kapazitäten des Digital-zu-Analog-Wandlers gekoppelt. Dieser Ausführungsform liegt die Erkenntnis zugrunde, dass es vorteilhaft ist, die Kapazität der Verbindungsleitung des Flächenlichtmodulators direkt in die kapazitiven Spannungsteiler einzubeziehen. Das Wegfallen eines Operationsverstärkers ist auf diese Weise ohne Einbußen der Genauigkeit möglich, da die zu bedienenden Lasten klein sind.

In der beanspruchten Ausführungsform ist der der Digital-zu-Analog-Wandler ausgelegt, um die Kapazität der Verbindungsleitung sowie von damit gekoppelten Halbleitergebieten gegen ein Referenzpotential in die kapazitive Spannungsteilung einzubeziehen. Dieser Ausführungsform liegt die Erkenntnis zugrunde, dass es vorteilhaft ist, wenn bei passend dimensionierten Kapazitäten weniger Leistung umgesetzt wird, als das in einer Schaltung mit einem zusätzlichen Operationsverstärker möglich gewesen wäre.

In der beanspruchten Ausführungsform sind die Digital-zu-Analog-Wandler und die mikromechanischen Aktuatoren, die bevorzugt in einem Flächenlichtmodulator (SLM-Chip) angeordnet sind, auf einem Halbleiterchip angeordnet. Dieser Ausführungsform liegt die Erkenntnis zugrunde, dass es von Vorteil ist, die Digital-zu-Analog-Wandler direkt auf dem SLM-Chip zu integrieren, um einen kompakten Aufbau des Gesamtsystems mit digitalem Interface zu ermöglichen. Dabei sollte die Leistungsaufnahme so klein wie mögliche gehalten werden, damit die für die Mikrospiegel notwendigen Spannungen bei möglichst hohen Frameraten erzeugt werden können und die Wärmeentwicklung des Gesamtsystems in annehmbaren Grenzen bleibt. In einer weiteren Ausführungsform sind die mikromechanischen Aktuatoren in Spalten angeordnet, wobei eine Mehrzahl von Aktuatoren in einer Spalte mit einer gemeinsamen Verbindungsstruktur gekoppelt ist.

In einer weiteren Ausführungsform ist ein erster Teil der Aktuatoren in einer Aktuatorspalte mit einer ersten Spaltenleitung gekoppelt, und wobei ein zweiter Teil der Aktuatoren in der Aktuatorspalte mit einer zweiten Spaltenleitung gekoppelt ist, und wobei die Anordnung ausgelegt ist, um die erste Spaltenleitung und die zweite Spaltenleitung abwechselnd mit geschalteten Kondensatoren des Digital-zu-Analog-Wandlers oder gleichzeitig mit zwei verschiedenen Digital-zu-Analog-Wandlern zu koppeln.

Dieser Ausführungsform liegt die Erkenntnis zugrunde, dass es vorteilhaft ist, die Kapazität der Spaltenleitung bei gleichbleibender Geschwindigkeit des Digital-zu-Analog-Wandlers zu halbieren, wobei auch die auch die Kondensatoren des DACs entsprechend halbiert werden können, wobei sich die umgesetzte Leistung entsprechend verringert.

In einer weiteren Ausführungsform weist der Digital-zu-Analog-Wandler eine erste Gruppe von Kondensatoren auf, deren erste Anschlüsse gleichstrommäßig gekoppelt sind und deren zweite Anschlüsse abhängig von einem Digitalwert mit zumindest zwei verschiedenen Referenzpotenzialen verbindbar sind. Eines dieser beiden Referenzpotenziale, üblicherweise das niedrigere, kann dabei die Schaltungsmasse / GND sein. Dabei weist der Digital-zu-Analog-Wandler eine zweite Gruppe von Kondensatoren auf, deren erste Anschlüsse gleichstrommäßig gekoppelt sind, und deren zweite Anschlüsse abhängig von einem Digitalwert mit zumindest zwei verschiedenen Referenzpotenzialen verbindbar sind. Die ersten Anschlüsse der ersten Gruppe von Kondensatoren sind hier gleichstrommäßig mit der Verbindungsstruktur gekoppelt, wobei die ersten Anschlüsse der zweiten Gruppe von Kondensatoren über einen ersten Koppelkondensator mit den ersten Anschlüssen der ersten Gruppe von Kondensatoren gekoppelt sind. Dabei weist der Digital-zu-Analog-Wandler einen ersten Rücksetzschalter auf, der ausgelegt ist, um die ersten Anschlüsse der Kondensatoren der ersten Gruppe von Kondensatoren mit einem zugehörigen Referenzpotenzial zu koppeln; wobei der Digital-zu-Analog-Wandler einen zweiten Rücksetzschalter aufweist, der ausgelegt ist, um die ersten Anschlüsse der Kondensatoren der zweiten Gruppe von Kondensatoren mit einem zugehörigen Referenzpotenzial zu koppeln.

Diese Ausführungsform basiert auf der Erkenntnis, dass es vorteilhaft ist, wenn die Unterschiede der Kapazitäten der verwendeten Kondensatoren nicht zu groß werden.

In einer weiteren Ausführungsform weist der Digital-zu-Analog-Wandler eine erste Gruppe von Kondensatoren auf, deren erste Anschlüsse gleichstrommäßig gekoppelt sind und deren zweite Anschlüsse abhängig von einem Digitalwert mit zumindest drei verschiedenen Referenzpotentialen, darunter ggf. die Schaltungsmasse / GND, verbindbar sind, wobei die Auswahl der Referenzpotentiale von zumindest zwei Bits eines digitalen Wertes abhängig sind. Dabei weist der Digital-zu-Analog-Wandler eine zweite Gruppe von Kondensatoren auf, deren erste Anschlüsse gleichstrommäßig gekoppelt sind, und deren zweite Anschlüsse abhängig von einem Digitalwert mit zumindest drei verschiedenen Referenzpotentialen, darunter ggf. die Schaltungsmasse, verbindbar sind. Die ersten Anschlüsse der ersten Gruppe von Kondensatoren sind dabei gleichstrommäßig mit der Verbindungsstruktur gekoppelt und die ersten Anschlüsse der zweiten Gruppe von Kondensatoren sind über einen ersten Koppelkondensator mit den ersten Anschlüssen der ersten Gruppe von Kondensatoren gekoppelt. Dabei weist der Digital-zu-Analog-Wandler einen ersten Rücksetzschalter auf, der ausgelegt ist, um die ersten Anschlüsse der Kondensatoren der ersten Gruppe von Kondensatoren mit einem zugehörigen Referenzpotenzial zu koppeln. Zudem weist der Digital-zu-Analog-Wandler einen zweiten Rücksetzschalter auf, der ausgelegt ist, um die ersten Anschlüsse der Kondensatoren der zweiten Gruppe von Kondensatoren mit einem zugehörigen Referenzpotenzial zu koppeln.

Dieser Ausführungsform liegt die Erkenntnis zugrunde, dass es vorteilhaft ist an einer Lastkapazität in der Initialisierungsphase zunächst einen Bruchteil des Ausgangsspannungsbereichs anzulegen, wodurch die höchsten der benötigten Referenzspannungen oder die Kapazität der verwendeten Kondensatoren deutlich kleiner ausgelegt werden können. In einer solchen Ausführungsform kann die zweite Gruppe von Kondensatoren beispielsweise weniger verschiedene Kapazitäten aufweisen als die erste Gruppe von Kondensatoren.

In einer weiteren Ausführungsform kann die zweite Gruppe von Kondensatoren beispielsweise weniger verschiedene Kapazitäten aufweisen als die erste Gruppe von Kondensatoren.

In einer weiteren Ausführungsform weist der Digital-zu-Analog-Wandler eine dritte Gruppe von Kondensatoren auf, deren erste Anschlüsse gleichstrommäßig gekoppelt sind, und deren zweite Anschlüsse abhängig von einem Digitalwert mit zumindest zwei verschiedenen Referenzpotenzialen verbindbar sind. Dabei sind die ersten Anschlüsse der dritten Gruppe von Kondensatoren über einen zweiten Koppelkondensator mit den ersten Anschlüssen der zweiten Gruppe von Kondensatoren gekoppelt. Dabei weist der Digital-zu-Analog-Wandler einen dritten Rücksetzschalter auf, der ausgelegt ist, um die ersten Anschlüsse der Kondensatoren der dritten Gruppe von Kondensatoren mit einem zugehörigen Referenzpotenzial zu koppeln. Diese Ausführungsform basiert auf der Erkenntnis, dass es vorteilhaft ist, die dritten Gruppe von Kondensatoren über einen zweiten Koppelkondensator mit den ersten Anschlüssen der zweiten Gruppe von Kondensatoren zu koppeln, wobei eine weitere Verbesserung der Schaltung ermöglicht wird.

In einer weiteren Ausführungsform sind die Kapazitätswerte der ersten Gruppe von Kondensatoren binär abgestuft, wobei die Kapazitätswerte ein Vielfaches einer Grundkapazität aufweisen. Dabei sind auch die Kapazitätswerte der zweiten Gruppe von Kondensatoren binär abgestuft und weisen ein Vielfaches der Grundkapazität auf, wobei ein maximaler Kapazitätswert in der zweiten Gruppe von Kondensatoren höchstens die Hälfte des maximalen Kapazitätswerts in der ersten Gruppe von Kondensatoren beträgt. Diese Ausführungsform basiert auf der Erkenntnis, dass es vorteilhaft ist, durch diese Maßnahme zumindest den Kapazitätswert der Kondensatoren aus der zweiten Gruppe von Kondensatoren zu verringern.

In einer weiteren Ausführungsform sind die Kapazitätswerte der ersten Gruppe von Kondensatoren binär abgestuft, wobei die Kapazitätswerte ein Vielfaches einer Grundkapazität aufweisen. Dabei sind auch die Kapazitätswerte der zweiten Gruppe von Kondensatoren binär abgestuft und weisen ein Vielfaches der Grundkapazität auf, wobei ein maximaler Kapazitätswert in der zweiten Gruppe von Kondensatoren höchstens ein Viertel des maximalen Kapazitätswerts in der ersten Gruppe von Kondensatoren beträgt. Diese Ausführungsform basiert auf der Erkenntnis, dass es vorteilhaft ist, durch diese Maßnahme zumindest den Kapazitätswert der Kondensatoren aus der zweiten Gruppe von Kondensatoren noch weiter zu verringern.

In einer weiteren Ausführungsform weist der Digital-zu-Analog-Wandler einen ersten Rücksetzschalter auf, der die Verbindungsstruktur mit einem Referenzpotential koppeln kann. Diese Ausführungsform basiert auf der Erkenntnis, dass es vorteilhaft ist, mit dem ersten Rücksetzschalter beispielsweise die Kapazität der Verbindungsstruktur zu entladen oder auf ein gewünschtes Potential vorzuladen.

In einer weiteren Ausführungsform erfolgt ein Vorladen der Kapazität der Verbindungsstruktur und/oder der Kondensatoren der ersten Gruppe von Kondensatoren, die den höchstwertigen Bits zugeordnet sind, während einer Initialisierungsphase abhängig von einem digitalen Wert, bzw. abhängig von einem oder mehreren höchstwertigen Bits des digitalen Werts. Während dessen werden andere geschaltete Kondensatoren, die niederwertigeren Bits zugeordnet sind, auf datenunabhängige Spannungen vorgeladen. Dabei erfolgt anschließend nach Öffnen der reset-Schalter/preset-Schalter ein datenabhängiges Verbinden der zweiten Anschlüsse der Kondensatoren der ersten Gruppe von Kondensatoren und der zweiten Gruppe von Kondensatoren mit einer von zwei oder mehr verschiedenen Referenzspannungen.

In einer weiteren Ausführungsform ist zumindest eine erste der Verbindungsstrukturen in einer Initialisierungsphase, die der Bereitstellung eines Analogwerts auf der ersten Verbindungsstruktur zugeordnet ist, auf ein Potential vorgeladen, das unterhalb eines Zielpotentials für die erste Verbindungsstruktur liegt. Weiterhin ist zumindest eine zweite der Verbindungsstrukturen in einer Initialisierungsphase, die der Bereitstellung eines Analogwerts auf der zweiten Verbindungsstruktur zugeordnet ist, auf ein Potential vorgeladen, das oberhalb eines Zielpotentials für die zweite Verbindungsstruktur liegt. Dabei werden die zweiten Anschlüsse der Kondensatoren nach Abschluss der Initialisierungsphase, die der Bereitstellung eines Analogwerts auf der ersten Verbindungsstruktur zugeordnet ist, datenabhängig mit entsprechenden Referenzpotentialleitungen verbunden, um das Potential der ersten Verbindungsstruktur auf ein Zielpotential für die erste Verbindungsstruktur hochzuziehen. Weiterhin werden die zweiten Anschlüsse der Kondensatoren nach Abschluss der Initialisierungsphase, die der Bereitstellung eines Analogwerts auf der zweiten Verbindungsstruktur zugeordnet ist, datenabhängig mit entsprechenden Referenzpotentialleitungen verbunden, um das Potential der ersten Verbindungsstruktur auf ein Zielpotential für die zweite Verbindungsstruktur hinunterzuziehen.

In einer weiteren Ausführungsform ist in der Anordnung ein Multiplexer vorgesehen, wobei der Multiplexer wahlweise die geschalteten Kapazitäten des Digital-zu-Analog-Wandlers mit verschiedenen Verbindungsstrukturen und/oder Spaltenleitungen koppelt. Dieser Ausführungsform liegt die Erkenntnis zugrunde, dass es vorteilhaft ist einen Multiplexer einzusetzen, um bei einer gleichbleibenden Geschwindigkeit des Digital-zu-Analog-Wandlers beispielsweise eine Verringerung der Layout-Fläche einer solchen Schaltung zu erreichen.

In einer weiteren Ausführungsform ist die Anordnung so ausgelegt, um die Verbindungsstruktur als Zwischenspeicher für eine Ladung zu verwenden, und um die auf der Verbindungsstruktur gespeicherte Ladung nach Abtrennung der geschalteten Kapazitäten des Digital-zu-Analog-Wandlers von der Verbindungsstruktur zumindest teilweise zu einem Aktuator oder zu einer dem Aktuator vorteilhafterweise individuell zugeordneten Speicherkapazität zu übernehmen.

Gemäß einer weiteren Ausführungsform ist ein Verfahren zum Ansteuern von mikromechanischen Aktuatoren in einer Anordnung mit einer Mehrzahl von mikromechanischen Aktuatoren, die mit einer Verbindungsstruktur gekoppelt sind, so ausgelegt, dass eine an der Verbindungsstruktur anliegende Spannung durch eine einstellbare kapazitive Spannungsteilung, die von einem digitalen Eingangswert abhängig ist, bestimmt wird, und wobei eine Kapazität der Verbindungsstruktur in die kapazitive Spannungsteilung direkt einbezogen wird.

Gemäß einer weiteren Ausführungsform wird ein Computerprogramm zur Berechnung der an das SLM zu übertragenden Daten bereitgestellt, wobei das Computerprogramm auf einem Computer ausgeführt wird.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Ein erfindungsgemäß codiertes Signal kann auf einem digitalen Speichermedium gespeichert sein oder kann auf einem Übertragungsmedium wie beispielsweise einem drahtlosen Übertragungsmedium oder einem verdrahteten Übertragungsmedium, z.B. dem Internet, übertragen werden

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Nachstehend wird die Erfindung unter Bezugnahme auf die Figuren, auf die hinsichtlich aller erfindungswesentlichen und in der Beschreibung nicht näher herausgestellten Einzelheiten ausdrücklich Bezug genommen wird, erläutert. Alle für das unmittelbare Verständnis der Erfindung nicht wesentlichen Elemente sind weggelassen worden. Gleiche Elemente sind in den einzelnen Figuren mit den gleichen Bezugszeichen versehen.

Fig. 1 zeigt schematisch einen Flächenlichtmodulator mit analogen Dateneingängen sowie eine externe Ansteuerschaltung nach dem Stand der Technik,

Fig. 2 zeigt schematisch einen erfindungsgemäßen Flächenlichtmodulator mit digitalen Dateneingängen,

Fig. 3 zeigt schematisch eine DRAM-Struktur eines analogen Flächenlichtmodulators,

Fig. 4 zeigt schematisch ein Schaltbild eines herkömmlichen Digital-zu-Analog-Wandlers mit Ausgangs-Operationsverstärker,

Fig. 5 zeigt schematisch ein Schaltbild eines D/A-Wandlers einer erfindungsgemäßen Ansteuerschaltung,

Fig. 6 zeigt schematisch ein Diagramm der notwendigen Referenzspannung in Abhängigkeit von einer Spaltenkapazität,

Fig. 7 zeigt schematisch eine Spalten-Struktur eines Flächenlichtmodulators in zwei Ausführungsformen,

Fig. 8 zeigt schematisch ein Schaltbild eines D/A-Wandlers mit reduzierten Kapazitäten,

Fig. 9 zeigt schematisch ein Schaltbild eines D/A-Wandlers mit Initialisierung der Spaltenkapazität durch eine von mehreren Referenzspannungen,

Fig. 10 zeigt schematisch ein Schaltbild eines D/A-Wandlers mit mehreren Referenzspannungen, und

Fig. 11 zeigt schematisch ein Schaltbild eines D/A-Wandlers mit drei Referenzspannungen und Initialisierung der Spaltenkapazität.

Die Erfindung wird nachfolgend anhand von mehreren Ausführungsbeispielen näher erläutert.

Fig. 1 zeigt schematisch einen extern angesteuerten Flächenlichtmodulator 80, der in einer üblichen Bauform als zweidimensionale Matrix / SLM-Matrix 100 angedeutet ist. Die externe Ansteuerschaltung mit einer Mehrzahl von externen Digital-zu-Analog-Wandlern / DACs 103, dient zur Veränderung der Höhenlage und / oder Kippung einer Mehrzahl von Mikrospiegeln. Die Mikrospiegel, die auch als Pixel bezeichnet werden, verändern ihre Höhenlage und / oder Kippung, über entsprechend angesteuerte mikromechanische Aktuatoren. Die externen Digital-zu-Analog-Wandler / DACs 103 werden über einen Steuercomputer 150 mit digitalen Signalen angesteuert und liefern entsprechende analoge Signale (Spannungen) an ihrem Ausgang. Die analogen Spannungen werden anschließend über ein analoges SLM-Interface 160 über dessen analoge Multiplexer 106 an Spaltenleitungen 201 der SLM-Matrix 100 angelegt.

Neben der eigentlich gewünschten Last - dem mikromechanischen Aktuator - sind noch weitere parasitäre Lasten beispielhaft als Zuleitungen 102, Bondpads 104 dargestellt. Die Bondpads 104 sind zu kontaktierende Flächen eines Halbleiterelements, die beispielsweise für das Anschließen der Zuleitungen 102 dienen. Weiterhin können beispielsweise auch ESD-Schutzschaltungen (nicht dargestellt) als eine weitere parasitäre Last fungieren. Die beispielsweise aufgeführten Bauteile sind hauptsächlich dafür verantwortlich, dass bereits aufgrund ihrer Größe und Kapazität ein kompakter Gesamtaufbau des Flächenlichtmodulators SLM mit einer entsprechenden Ansteuerschaltung erschwert wird.

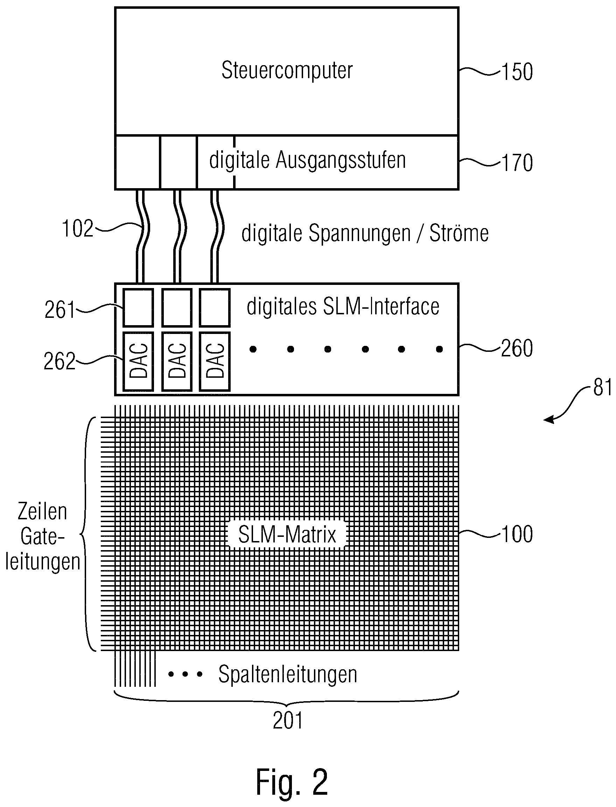

Fig. 2 zeigt eine erfindungsgemäße Ausführungsform eines Flächenlichtmodulators 81, der ein digitales SLM-Interface 260 aufweist. Das digitale SLM-Interface 260 dieser Ausführungsform weist seinerseits eine Mehrzahl von digitalen Eingangsstufen 261 auf, die für den Empfang von digitalen Signalen (Spannungen / Strömen) vorgesehen sind, die über die Zuleitungen 102 direkt von digitalen Ausgangsstufen 170 des Steuercomputers 150 eingespeist werden können. Im digitalen SLM-Interface 260 ist darüber hinaus eine Mehrzahl von Digital-zu-Analog-Wandler 262 angeordnet. Die Digital-zu-Analog-Wandler 262 ermöglichen das Ansteuern der SLM-Matrix 100 über deren Spaltenleitungen 201 mit analogen Spannungswerten.

Fig. 3 zeigt schematisch einen beispielhaften Teilbereich einer SLM-Matrix 100 mit sechs gleichen Speicherzellen, die je einer von sechs Pixeln der SLM-Matrix 100 entsprechen. Eine dieser Speicherzellen des dargestellten Teilbereichs, die einem Pixel entspricht, ist anhand einer entsprechenden DRAM-Struktur grau hinterlegt dargestellt.

Unter jedem mikromechanischen Aktuator / Pixel ist ein solcher elektronischer Speicherbaustein mit wahlfreiem Zugriff angeordnet. Eine analoge DRAM-Zelle mit einem Transistor, z. B. einem Pixeltransistor 203, und einer Speicherkapazität / einem Speicherkondensator 205, speichert einen Adressspannungswert bis zu einem nächsten Refresh. Die mit grau hinterlegt dargestellte DRAM-Struktur ist weiterhin durch eine Aktuatorkapazität und einer pn-junction-Kapazität 207 gekennzeichnet. Die pn-junction-Kapazität 207 tritt am Materialübergang in Halbleiterkristallen zwischen Bereichen mit entgegengesetzter Dotierung des Pixeltransistors 203 auf.

Eine analoge Spannung wird beispielsweise zeilenweise in die SLM-Matrix 100 eingeschrieben. Dafür werden alle Gates der Pixeltransistoren 203 einer Zeile geöffnet während zur gleichen Zeit die Spaltenleitungen 201 und damit die Sources der Pixeltransistoren 203 jeweils die gewünschten Spannungen haben. Mit dem Schließen der Gates der Pixeltransistoren 203 sind die angelegten Spannungen in den Kapazitäten der Pixelzellen dieser Zeile gespeichert. Alle Pixeltransistor-Sources einer Spalte sind mit der Spaltenleitung 201 verbunden. Die Gesamtkapazität einer solchen Spaltenleitung 201 wird im Wesentlichen durch die pn-Kapazität 207 eines sogenannten Sourcegebiets der Pixeltransistoren 203 bestimmt und steigt daher mit der Größe des Arrays an.

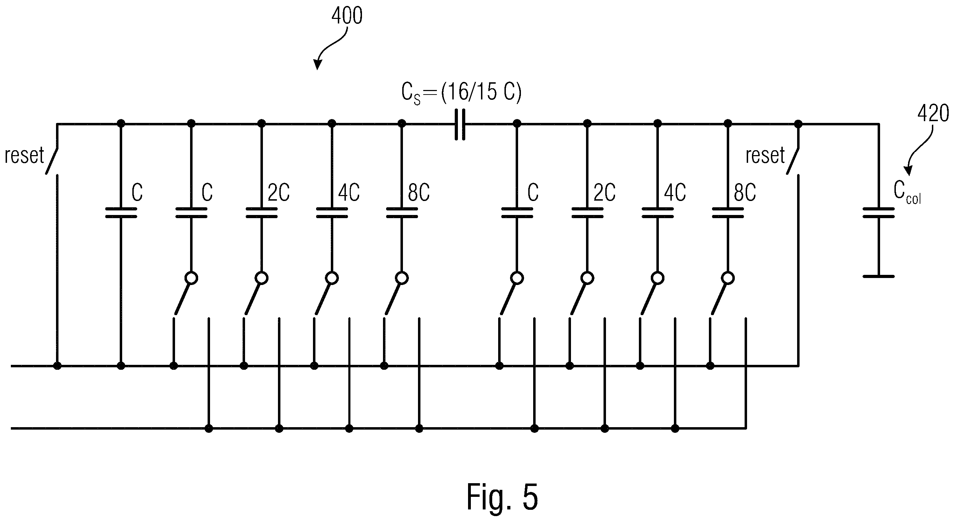

Fig. 5 zeigt ein Schaltbild eines Digital-zu-Analog-Wandlers 400 einer erfindungsgemäßen Ansteuerschaltung zum Ansteuern von mikromechanischen Aktuatoren. Das Schaltbild entspricht einem Bereich eines SLM-Chips zwischen einem digitalen Dateninterface sowie den mikromechanischen Aktuatoren. Ein Digital-zu-Analog-Wandler wird auch als DAC bezeichnet (DAC, Englisch für: Digital Analog Converter).

Dabei stellt Fig. 5 eine Sonderform eines Digital-zu-Analog-Wandlers dar, nämlich einen sogenannten Charge Scaling DAC, wobei hier die Kapazität der SLM-Spaltenleitung direkt als Nutzkapazität in die kapazitiven Spannungsteiler mit den vorhandenen Charge Scaling Kapazitäten einbezogen sind und keine Operationsverstärker (OPVs) verwendet werden, wie das bei herkömmlichen Digital-zu-Analog-Wandlern der Fall ist.

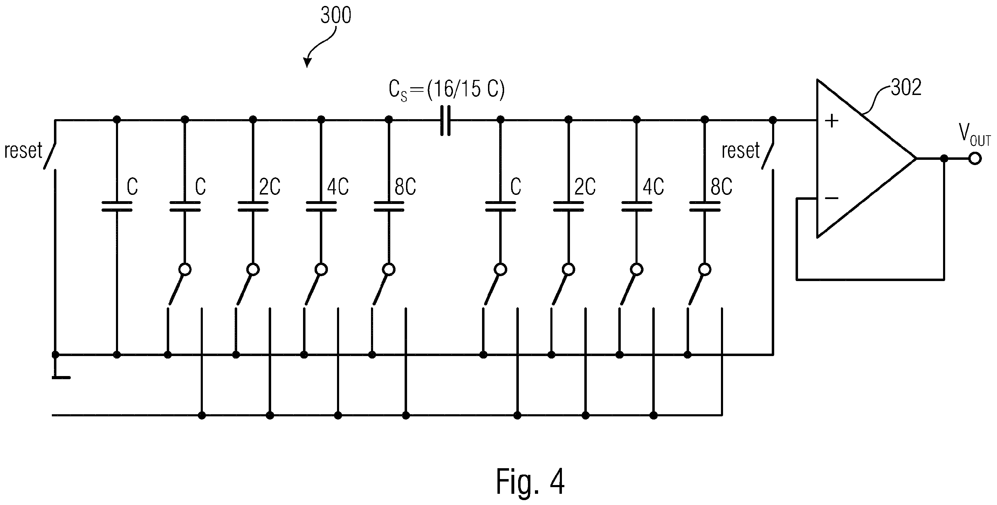

Fig. 4 zeigt ein Schaltbild eines solchen herkömmlichen Digital-zu-Analog-Wandlers (DAC) 300 mit einem Operationsverstärker (OPV) 302, der eine Referenzspannung $V_{ref}$ aufweist. Ein solcher DAC 300 könnte auch alternativ mit Widerstandsketten oder Stromspiegeln realisiert werden, kann dann aber eine erheblich größere Verlustleistung aufweisen. Der hier gezeigte Digital-zu-Analog-Wandler 300 hingegen basiert, wie der DAC 400 aus Fig. 5, auf einem sogenannten Charge Scaling Konzept, das Kapazitäten aufweist, mit denen ein vergleichsweise verlustarmer Betrieb möglich ist.

Der Digital-zu-Analog-Wandler aus Fig. 4 weist einen sogenannten Unity-Gain OPV 302 am Ausgang als Impedanzwandler auf, um eine lastunabhängige Spannung zur Verfügung zu stellen. Dieser OPV 302 benötig zusätzlich eine höhere Leistungsaufnahme, die mit der Geschwindigkeit im Betrieb ansteigen kann. Zusätzlich sollten in diesem Fall weitere Faktoren wie beispielsweise Linearität und Einschwingverhalten beachtet werden, wobei ein nachteiliges Verhalten der herkömmlichen Digital-zu-Analog-Wandler ersichtlich wird. Darüber hinaus können OPVs auch sehr anfällig für eine Fehlanpassung ("Mismatch") in der Differenzeingangsstufe sein. Dies kann dann von besonderer Bedeutung sein, da hier hunderte OPVs parallel integriert werden und dies die Ausbeute beispielsweise im Bestückungsprozess/Fertigungsprozess stark reduzieren kann.

Um einen kompakten Aufbau des Gesamtsystems mit digitalem Interface zu ermöglichen, sind die Digital-zu-Analog-Wandler 400 gemäß dem Ausführungsbeispiel mit dem Digital-zu-Analog-Wandler aus Fig. 5 auf dem SLM-Chip integriert. Dabei kann die Leistungsaufnahme so klein wie mögliche gehalten werden, damit die für die Mikrospiegel notwendigen Spannungen bei möglichst hohen Frameraten erzeugt werden können und die Wärmeentwicklung trotzdem moderat bleibt. Aus der Größe der Spaltenkapazität $C_{col}$ 420, der Spannung und der Refreshrate ergibt sich eine Mindestleistungsaufnahme. Durch die integrierten DACs, sollte möglichst wenig zusätzliche Energie verbraucht werden.

Das Ausführungsbeispiel des Digital-zu-Analog-Wandlers 400 aus Fig. 5 entspricht einem SLM-Chip mit integriertem digitalen Dateninterface und Charge Scaling DACs. Die Kapazität der SLM-Spaltenleitung ist hier direkt in die kapazitiven Spannungsteiler einbezogen, wobei keine OPVs benötigt werden. Dadurch kann, ohne Einbußen der Genauigkeit, eine eventuelle Verlustleistung von Operationsverstärkern eingespart werden, da die von den Digital-zu-Analog-Wandlern zu bedienenden Lasten klein und recht genau bekannt, sowie alle praktisch gleich groß sind.

Damit eine gewünschte Spannung auf der Spaltenkapazität $C_{col}$ 420 erreicht werden kann, muss bei einem sogenannten Cascode Charge Scaling DAC mit Charge Scaling Kapazitäten, der aber keinen OPV benötigt, wie in gemäß Fig. 5 eine von dem Verhältnis DAC-Einheitskapazität C zu $C_{col}$ abhängige, höhere Referenzspannung angelegt werden, wie aus der folgenden Gleichung ersichtlich.

$$V_{ref} = V_{col\_max} \frac{C_{DAC} + C_{col}}{C_{DAC}} = V_{col\_max} \frac{16C + C_{col}}{16C} \rightarrow$$

$$\frac{V_{ref}}{V_{col\_max}} = 1 + \frac{C_{col}}{C}$$

Dies kann zunächst die Leistungsbilanz verschlechtern, jedoch wird bei ausreichend großen Kapazitäten weniger Leistung umgesetzt, als im mit zusätzlichem OPV, wobei die Referenzspannung weniger hoch sein darf. Ist die Referenzspannung dem Verhältnis entsprechend erhöht, hängt die erreichte Spaltenspannung $V_{col}$ direkt linear von der geschalteten Kapazität des DACs ab, wie aus der folgenden Gleichung ersichtlich.

$$V_{col} = V_{ref} \frac{C_{DAC\_on\_bits}}{C_{col} + C_{DAC\_all\_bits}}$$

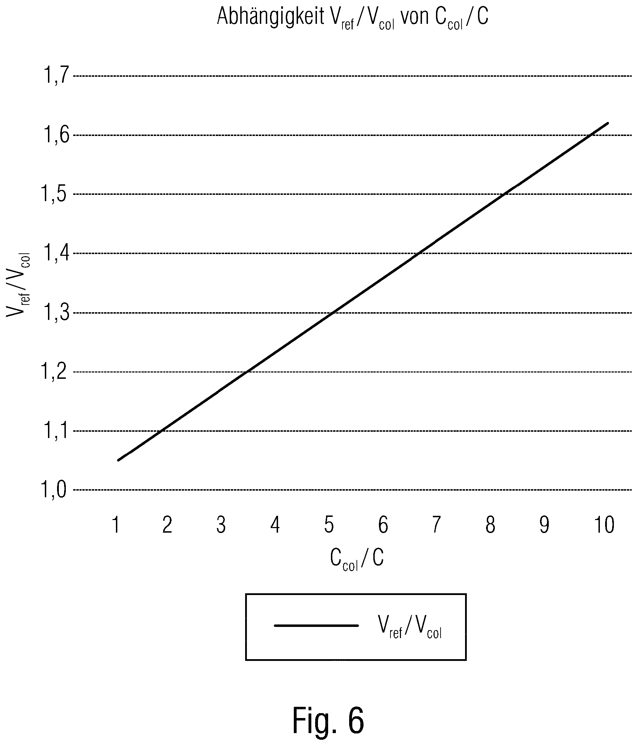

Fig. 6 stellt diesbezüglich in einem Diagramm die Abhängigkeit der benötigten Spannung vom Verhältnis (DAC-) Einheitskapazität zur Spaltenkapazität dar.

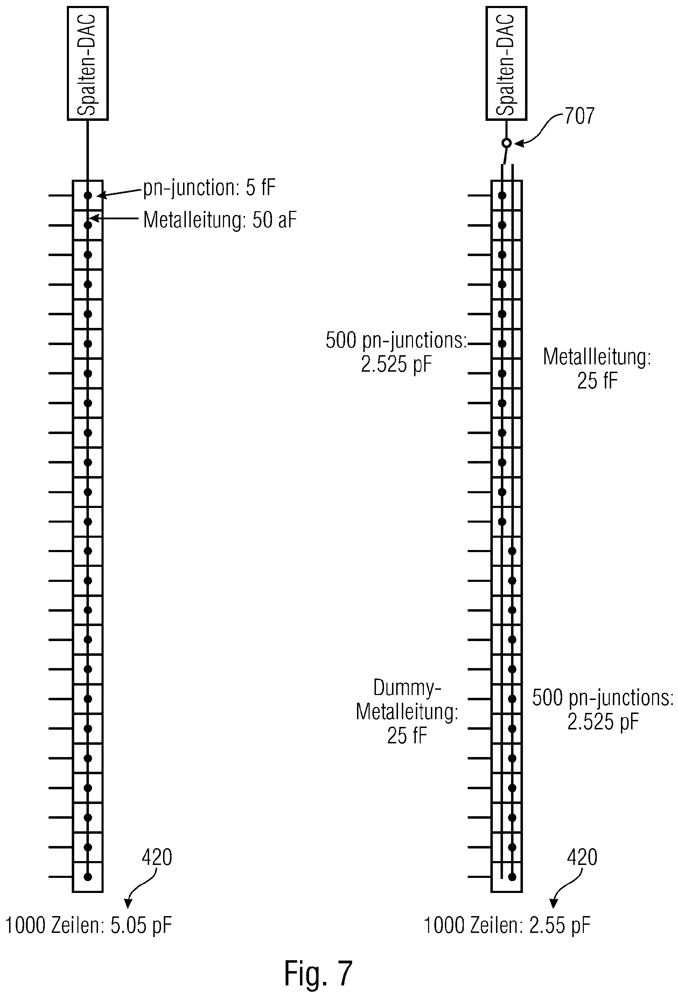

Fig. 7 zeigt ein Ausführungsbeispiel, bei der eine Möglichkeit zur Reduzierung der Größe der Charge Scaling Kapazitäten dargestellt ist. Durch eine Teilung der Spalten halbiert sich die Kapazität der Spaltenleitung bei gleichbleibender Geschwindigkeit des Digital-zu-Analog-Wandlers. Durch diese Maßnahme kann auch die Kapazität der Kondensatoren des Digital-zu-Analog-Wandlers halbiert werden, ohne dass die Referenzspannung erhöht werden muss.

Damit kann eine benötige Layout-Fläche auf dem SLM-Chip vorteilhaft reduziert werden. Für diese Anordnung ist allerdings als zusätzliches elektronisches Bauelement ein AnalogMultiplexer 707 erforderlich. Ein weiterer Vorteil dieser Anordnung ermöglicht neben der Einsparung der Layout-Fläche auf dem SLM-Chip auch eine Reduzierung der im SLM-Chip umgesetzten Leistung um etwa die Hälfte.

Diese Teilung der Spalten kann in mehr als zwei Abschnitte durchgeführt werden. Einschränkend muss darauf geachtet werden, dass die zusätzlichen Spaltenleitungen durch die Pixelzelle geführt werden. Bei sehr hohen Teilfaktoren wäre dann beispielsweise ein erhöhter konstruktiver Aufwand nötig, verursacht durch die zusätzlichen Spaltenleitungen und den zusätzlich benötigten Multiplexer 707.

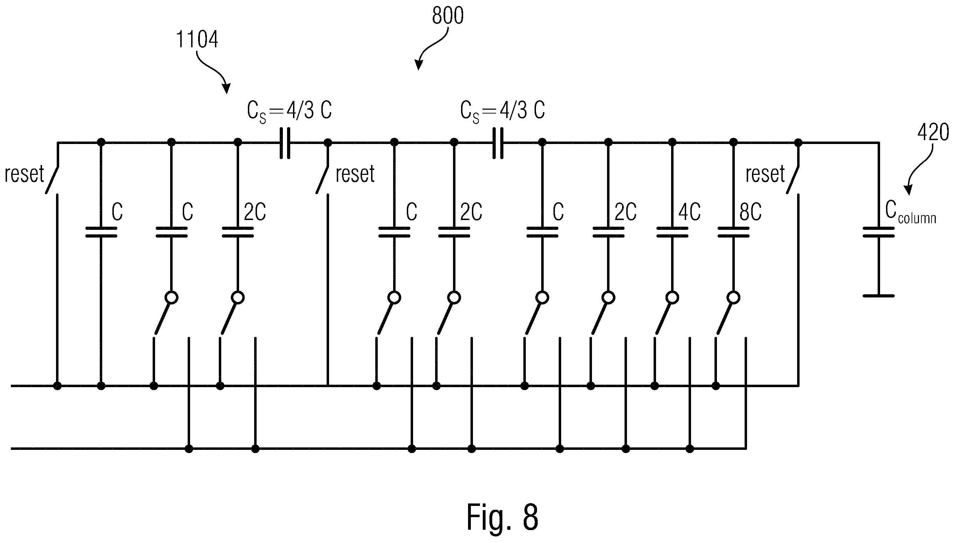

Fig. 8 zeigt ein weiteres Ausführungsbeispiel eines Digital-zu-Analog-Wandlers 800, mit dem eine weitere Reduktion der nötigen Gesamtkapazität ermöglicht wird. Damit können die Verlustleistung und die Layout-Fläche auf dem SLM-Chip weiter reduziert werden. Dabei werden die niederwertigen Bits der Kaskodenschaltung durch eine C/2C-Kette oder durch eine Zwei-Bit-Kaskodenschaltung ersetzt. Hier wird bei gleicher Präzision eine Kapazität von nur ca. 2,17C pro Bit benötigt, während es bei der Vier-Bit-Kaskodenschaltung nach Fig. 5 mehr als 4C pro Bit sind.

Als Koppelkondensator $C_S$ 1104 ist hier 4/3 C gewählt, da so eine gleichmäßige Abstufung der Analogwerte mit steigendem Datenwert entsteht. Abweichende Werte des Koppelkondensators $C_S$ 1104 könnten hier zu ungleichmäßigen Stufen der resultierenden Spannungen führen. Eine geeignete Kalibrierung kann dann für eine erhöhte Präzision sorgen.

Im Allgemeinen ist der optimale Wert des Koppelkondensators n/(n-1) C, wobei n die Anzahl der unterschiedlichen möglichen Werte der anzukoppelnden, niederwertigeren Stufe der Schaltung bezeichnet, beispielsweise in Fig. 5 n=4 für die Zwei-Bit-Stufen.

Um die vorangehend beschriebene Erhöhung der Referenzspannung im Rahmen zu halten, sollten bei diesem Ausführungsbeispiel die hochwertigen Bits der Kaskodenschaltung nicht durch entsprechende Schaltungen der niederwertigen Bits ersetzt werden. Die größeren Kapazitäten dieses Bereichs mit den hochwertigen Bits in der Kaskodenschaltung ermöglichen eine Begrenzung der Referenzspannung.

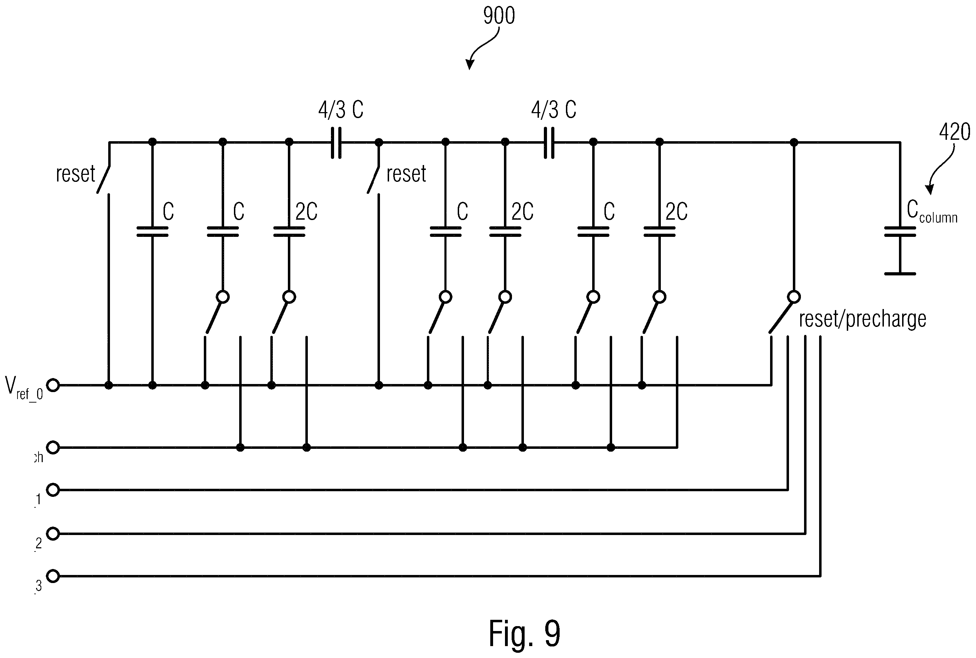

Fig. 9 zeigt ein weiteres Ausführungsbeispiel eines Digital-zu-Analog-Wandlers 900, bei dem eine weitere Verbesserung der Leistungsmerkmale erreicht werden kann. Dieser Effekt kann durch das Vorladen der Spaltenkapazität 420 auf eine Teilspannung in der Initialisierungsphase des DACs erfolgen.

In diesem Ausführungsbeispiel werden vier Referenzspannungen bereitgestellt, die über Reset- und Preset-Schalter zuschaltbar sind. Eine davon, üblicherweise die kleinste, kann wieder die Schaltungsmasse sein. Dabei wird die Lastkapazität in einem ersten_Schritt zunächst entsprechend den beiden höchstwertigen Datenbits auf die einem Zielwert nächstniedrigere Referenzspannung vorgeladen, während die Kondensatoren der Ladungsteiler-Schaltung zurückgesetzt (resettet) werden, indem ein Massenschluss erfolgt.

Nach dem Öffnen der Initialisierungs-Schalter (Reset- und Preset) werden die Kondensatoren der Ladungsteiler-Schaltung in einem zweiten Schritt entsprechend der restlichen Datenbits mit einer der Referenzspannungen beaufschlagt oder auf Masse gehalten. Da in diesem zweiten Schritt an der Lastkapazität nur ein Bruchteil des Ausgangsspannungsbereichs bedient werden muss, kann die höchste der Referenzspannungen kleiner ausfallen oder die Kapazität der Kondensatoren niedriger dimensioniert werden.

Bei diesem Ausführungsbeispiel sollte beachtet werden, dass die Mehrzahl von Referenzspannungen entsprechend stabil und belastbar zur Verfügung stehen sollte. Die Bereitstellung dieser festen Referenzspannungen erfolgt durch die Ansteuerschaltung, wobei eine gewisse Verlustleistung und ein eventuell höherer Schaltungsaufwand in Betracht gezogen werden sollte. Dafür werden ausreichend vielen Bondpads auf den SLM-Chip benötigt, um in jedem Teil des SLM-Chips präzise zur Verfügung zu stehen, wobei die Zahl der Interface-Leitungen erhöht sein kann. Bei aufwändigeren SLM-Chips mit Millionen von Mikrospiegeln stehen die Vorteile dieses Ausführungsbeispiels aber im Vordergrund.

Alternativ zu dem Ausführungsbeispiel aus Fig. 9, kann die Ladungsteilerschaltung auch mit einer der Referenzspannungen für die Initialisierung der Spaltenleitung betrieben werden, was die Bereitstellung einer weiteren Referenzspannung einspart.

Alternativ kann das Vorladen der Lastkapazität auch auf die nächsthöhere Referenzspannung erfolgen, während die restlichen Datenbits mit ihrer Referenzspannung beaufschlagt werden. Im zweiten Schritt wurden dann je nach zu konvertierendem Digitalwert die entsprechenden Datenbits mit Massenschluss versehen. Für sich genommen ist diese Alternative gleichwertig zur vorigen Version, aber wenn in einem SLM-Chip mit sehr vielen Pixeln typischerweise alle Datenwerte gleichberechtigt vorkommen, kann das gleichzeitige Nutzen beider Versionen - zum Beispiel Spaltenweise abwechselnd - die dynamische Last auf den Referenzspannungen im Mittel beträchtlich verringern, wobei die Präzision erhöht werden kann.

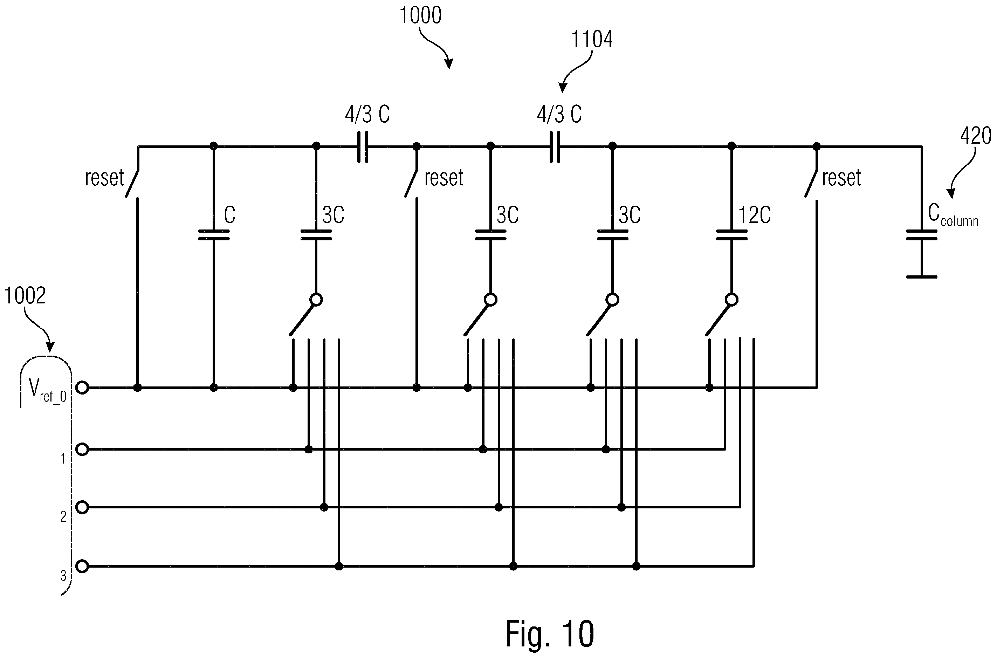

Fig. 10 bezieht sich auf eine Variante eines Digital-zu-Analog-Wandlers 1000 mit beispielsweise vier Referenzspannungen 1002. In diesem Ausführungsbeispiel werden die Referenzspannungen in allen Stufen der Ladungsteilerschaltung verwendet. Damit werden weniger Stufen in der Ladungsteilerschaltung benötigt, da jede dieser Stufen nun mehr als ein Datenbit repräsentiert. Diese werden nicht in jedem Takt voll aufgeladen und wieder entladen, was die Verlustleistung bei erhöhte Präzision reduzieren kann.

Alternativ kann eine andere Anzahl n von Referenzspannungen genutzt werden. Der optimale Wert des Koppelkondensators 1104 ist wieder n/(n-1) C, wobei abweichende Werte zu ungleichmäßigen Stufen der resultierenden Spannungen führen könnten. Eine geeignete Kalibrierung kann in diesem Fall für eine erhöhte Präzision sorgen.

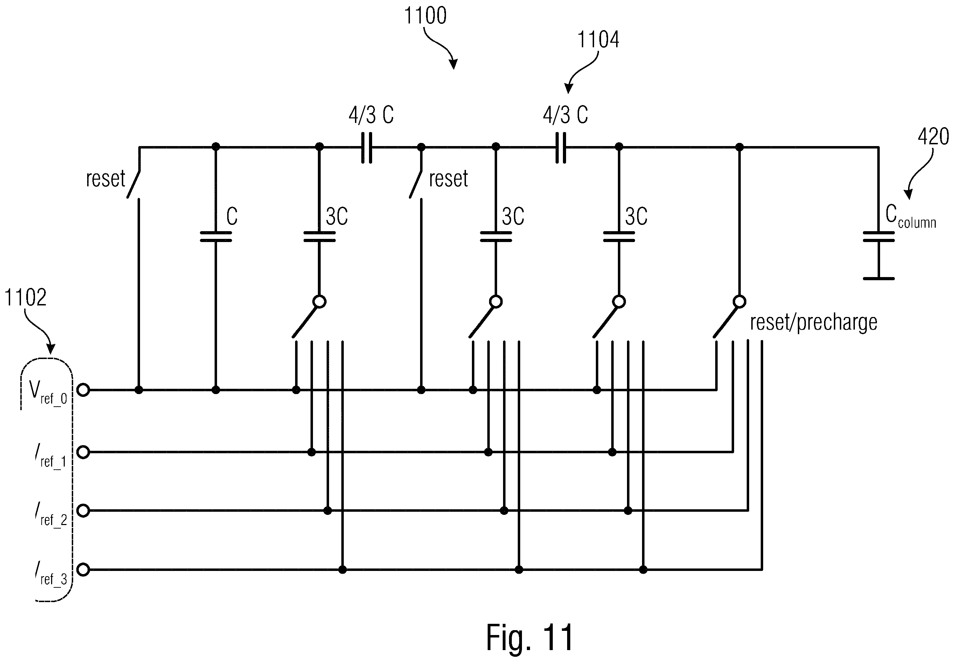

Fig. 11 zeigt ein Ausführungsbeispiel eines Digital-zu-Analog-Wandlers 1100, bei dem wieder mehrere Referenzspannungen 1102 zur Verfügung stehen. Diese werden hier wie in Fig. 10 zur Ansteuerung der DAC-Stufen genutzt, sowie gleichzeitig auch wie in Fig. 9 zur Initialisierung der Lastkapazität. Die Vorteile beider obigen Varianten können so kombiniert werden.

**Patentansprüche**

1.  Anordnung von mikromechanischen Aktuatoren mit integrierter Ansteuerschaltung mit folgenden Merkmalen:

    - einem Digital-zu-Analog-Wandler (103); und
    - einer Mehrzahl von mikromechanischen Aktuatoren; wobei
    - die mikromechanischen Aktuatoren mit einer Verbindungsstruktur elektrisch gekoppelt sind; wobei
    - der Digital-zu-Analog-Wandler (103) ausgelegt ist, um eine an die Verbindungsstruktur anzulegende Spannung durch eine einstellbare kapazitive Spannungsteilung, die von einem digitalen Eingangswert des Digital-zu-Analog-Wandlers abhängig ist, bereitzustellen, wobei
    - der Digital-zu-Analog-Wandler (103) ausgelegt ist, um eine Kapazität der Verbindungsstruktur direkt in die kapazitive Spannungsteilung einzubeziehen, wobei
    - der Digital-zu-Analog-Wandler (103) und die mikromechanischen Aktuatoren auf ein- und demselben Halbleiterchip angeordnet sind,
    wobei die Verbindungsstruktur eine Verbindungsleitung und eine Mehrzahl von Schalttransistoren umfasst, die zwischen Verbindungsleitung und Speicherkapazitäten geschaltet sind, die den jeweiligen mikromechanischen Aktuatoren zugeordnet sind, und
    - wobei die Verbindungsleitung passiv mit einer Mehrzahl von Kondensatoren gekoppelt ist, die zu einer einstellbaren Spannungsteilung dienen.

2.  Anordnung nach Anspruch 1, wobei

    - die Verbindungsleitung gleichstrommäßig oder direkt mit einer Mehrzahl von geschalteten Kapazitäten des Digital-zu-Analog-Wandlers (103) gekoppelt ist.

**3.** Anordnung nach einem der Ansprüche 1 oder 2, wobei

- der Digital-zu-Analog-Wandler (103) ausgelegt ist, um die Kapazität der Verbindungsleitung sowie von damit gekoppelten Halbleitergebieten gegen ein Referenzpotential in die kapazitive Spannungsteilung einzubeziehen.

**4.** Anordnung nach einem der Ansprüche 1 bis 3, wobei

- die mikromechanischen Aktuatoren in einem Flächenlichtmodulator (80) angeordnet sind.

**5.** Anordnung nach einem der Ansprüche 2 bis 6, wobei

- die mikromechanischen Aktuatoren in Spalten angeordnet sind, wobei eine Mehrzahl von Aktuatoren in einer Spalte mit einer gemeinsamen Verbindungsstruktur gekoppelt ist.

**6.** Anordnung nach einem der Ansprüche 1 bis 5, wobei

- ein erster Teil der Aktuatoren in einer Aktuatorspalte mit einer ersten Spaltenleitung gekoppelt sind, und wobei
- ein zweiter Teil der Aktuatoren in der Aktuatorspalte mit einer zweiten Spaltenleitung gekoppelt sind, und wobei
- die Anordnung ausgelegt ist, um die erste Spaltenleitung und die zweite Spaltenleitung abwechselnd mit geschalteten Kondensatoren des Digital-zu-Analog-Wandlers (103) oder gleichzeitig mit zwei verschiedenen Digital-zu-Analog-Wandlern zu koppeln.

**7.** Anordnung nach einem der Ansprüche 3 bis 6, wobei

- ein erster Rücksetzschalter die Verbindungsstruktur mit einem Referenzpotential koppeln kann.

**8.** Anordnung nach einem der Ansprüche 3 bis 7, wobei

- in der Anordnung ein Multiplexer (106) vorgesehen ist, wobei der Multiplexer (106) wahlweise die geschalteten Kapazitäten des Digital-zu-Analog-Wandlers (103) mit verschiedenen Verbindungsstrukturen und/oder Spaltenleitungen (201) koppelt.

**9.** Verfahren zum Ansteuern von mikromechanischen Aktuatoren in einer Anordnung gemäß einem der Ansprüche 1 bis 8, wobei

- eine an der Verbindungsstruktur anliegende Spannung durch eine einstellbare kapazitive Spannungsteilung, die von einem digitalen Eingangswert abhängig ist, bestimmt wird, und wobei
- eine Kapazität der Verbindungsstruktur in die kapazitive Spannungsteilung direkt einbezogen wird.

**10.** Computerprogramm zur Durchführung des Verfahrens gemäß Anspruch 9, wenn das Computerprogramm auf einem Computer ausgeführt wird.

**Claims**

**1.** Arrangement of micromechanical actuators with integrated control circuit, comprising:

- a digital-to-analog converter (103); and
- a plurality of micromechanical actuators; wherein
- the micromechanical actuators are electrically coupled to a connecting structure; wherein
- the digital-to-analog converter (103) is configured to provide a voltage to be applied to the connecting structure by an adjustable capacitive voltage division that is dependent on a digital input value of the digital-to-analog converter, wherein
- the digital-to-analog converter (103) is configured to directly incorporate a capacitance of the connecting structure into the capacitive voltage division, wherein
- the digital-to-analog converter (103) and the micromechanical actuators are arranged on one and the same semiconductor chip,
wherein the connecting structure includes a connecting line and a plurality of switching transistors connected between the connecting line and storage capacitors associated with the respective micromechanical actuators, and
- wherein the connecting line is passively coupled to a plurality of capacitors that serve to provide an adjustable voltage division.

2.  Arrangement as claimed in claim 1, wherein

- the connecting line is DC-coupled or directly coupled to a plurality of switched capacitances of the digital-to-analog converter (103).

3.  Arrangement as claimed in any one of claims 1 or 2, wherein

- the digital-to-analog converter (103) is configured to incorporate the capacitance of the connecting line and of semiconductor regions coupled thereto into the capacitive voltage division toward a reference potential.

4.  Arrangement as claimed in any one of claims 1 to 3, wherein

- the micromechanical actuators are arranged inside a spatial light modulator (80).

5.  Arrangement as claimed in any one of claims 2 to 6, wherein

- the micromechanical actuators are arranged in columns, wherein a plurality of actuators in one column are coupled to a common connecting structure.

6.  Arrangement as claimed in any one of claims 1 to 5, wherein

- a first portion of the actuators in an actuator column are coupled to a first column line, and wherein
- a second portion of the actuators in the actuator column are coupled to a second column line, and wherein
- the arrangement is configured to alternately couple the first column line and the second column line to switched capacitors of the digital-to-analog converter (103) or to simultaneously couple them to two different digital-to-analog converters.

7.  Arrangement as claimed in any one of claims 3 to 6, wherein

- a first reset switch may couple the connecting structure to a reference potential.

8.  Arrangement as claimed in any one of claims 3 to 7, wherein

- a multiplexer (106) is provided in the arrangement, said multiplexer (106) selectively coupling the switched capacitances of the digital-to-analog converter (103) to different connecting structures and/or column lines (201).

9.  Method of controlling micromechanical actuators in an arrangement as claimed in any one of claims 1 to 8, wherein

- a voltage present at the connecting structure is determined by an adjustable capacitive voltage division that is dependent on a digital input value, and wherein
- a capacitance of the connecting structure is directly incorporated into the capacitive voltage division.

10. Computer program for performing the method as claimed in claim 9, when the computer program is executed on a computer.

**Revendications**

1.  Dispositif d'actionneurs micromécaniques comprenant un circuit de commande intégré avec les caractéristiques suivantes :

- un convertisseur numérique-analogique (103) ; et
- une pluralité d'actionneurs micromécaniques ; dans lequel

- les actionneurs micromécaniques sont couplés électriquement à une structure de connexion ; dans lequel
- le convertisseur numérique-analogique (103) est conçu pour fournir une tension à appliquer à la structure de connexion par l'intermédiaire d'une division de tension capacitive réglable qui dépend d'une valeur d'entrée numérique du convertisseur numérique-analogique, dans lequel
- le convertisseur numérique-analogique (103) est conçu pour inclure une capacité de la structure de connexion directement dans la division de tension capacitive, dans lequel
- le convertisseur numérique-analogique (103) et les actionneurs micromécaniques sont disposés sur une seule et même puce semiconductrice,

dans lequel la structure de connexion comprend une ligne de connexion et une pluralité de transistors de commutation qui sont commutés entre la ligne de connexion et des condensateurs de stockage qui sont associés aux actionneurs micromécaniques respectifs, et

dans lequel la ligne de connexion est couplée de manière passive à une pluralité de condensateurs qui servent à une division de tension réglable.

2.  Dispositif selon la revendication 1, dans lequel

- la ligne de connexion est couplée en courant continu ou directement couplée à une pluralité de capacités commutées du convertisseur numérique-analogique (103).

3.  Dispositif selon une des revendications 1 ou 2, dans lequel

- le convertisseur numérique-analogique (103) est conçu pour inclure la capacité de la ligne de connexion ainsi que des régions semi-conductrices couplées à celle-ci par rapport à un potentiel de référence dans la division de tension capacitive.

4.  Dispositif selon une des revendications 1 à 3, dans lequel

- les actionneurs micromécaniques sont disposés dans un modulateur de lumière de surface (80).

5.  Dispositif selon une des revendications 2 à 6, dans lequel

- les actionneurs micromécaniques sont disposés en colonnes, dans lequel une pluralité d'actionneurs dans une colonne sont couplés à une structure de connexion commune.

6.  Dispositif selon une des revendications 1 à 5, dans lequel

- une première partie des actionneurs dans une colonne d'actionneurs est couplée à une première ligne de colonne, et dans lequel
- une seconde partie des actionneurs dans la colonne d'actionneurs est couplée à une seconde ligne de colonne, et dans lequel
- le dispositif est conçu pour coupler la première ligne de colonne et la seconde ligne de colonne alternativement à des condensateurs commutés du convertisseur numérique-analogique (103) ou simultanément à deux convertisseurs numériques-analogiques différents.

7.  Dispositif selon une des revendications 3 à 6, dans lequel

- un premier commutateur de réinitialisation peut coupler la structure de connexion à un potentiel de référence.

8.  Dispositif selon une des revendications 3 à 7, dans lequel

- dans le dispositif un multiplexeur (106) est prévu, dans lequel le multiplexeur (106) couple sélectivement les capacités commutées du convertisseur numérique-analogique (103) à différentes structures de connexion et/ou lignes de colonne (201).

9.  Procédé destiné à commander des actionneurs micromécaniques dans un dispositif selon une des revendications 1 à 8, dans lequel

- une tension appliquée à la structure de connexion est définie par une division de tension capacitive réglable qui dépend d'une valeur d'entrée numérique, et dans lequel
- une capacité de la structure de connexion est directement incluse dans la division de tension capacitive.

10. Programme d'ordinateur destiné à réaliser le procédé selon la revendication 9 lorsque le programme d'ordinateur est exécuté sur un ordinateur.

Fig. 1

Fig. 2

100

Spaltenleitung
201

Aktuator-
Gegenelektrode

pn-junction-
Kapazität
207

Pixel

Zeilen-Gate-
Leitung

S

D

C

Pixeltransistor
203

Aktuatorkapazität

Speicherkondensator
205

Fig. 3

Fig. 4

Fig. 5

EP 3 850 614 B1

Abhängigkeit $V_{ref}/V_{col}$ von $C_{col}/C$

Fig. 6

pn-junction: 5 fF

Metalleitung: 50 aF

500 pn-junctions: 2.525 pF

Metallleitung: 25 fF

707

Dummy-Metalleitung: 25 fF

500 pn-junctions: 2.525 pF

420

420

1000 Zeilen: 5.05 pF

1000 Zeilen: 2.55 pF

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2016111058 A1
- US 2012274611 A1
- US 2016078842 A1
- US 2015348492 A1
- US 2009204350 A1
- WO 2013131071 A1